# EUROPEAN PATENT APPLICATION

(11) **EP 2 346 308 A1**
(43) Date of publication of application: **20.07.2011**
(21) Application number: 10150797.8
(22) Date of filing: 14.01.2010
(51) Int. Cl.: H05K 3/12

(54) **Apparatus and method for treating a substance at a substrate**

(71) Applicant: Nederlandse Organisatie voor Toegepast -Natuurwetenschappelijk Onderzoek TNO, 2628 VK Delft (NL)
(72) Inventor: Klokkenburg, Mark, 3571 NA Utrecht (NL); Andriessen, Hieronymous Antonius Josephus Maria, 2340 Beerse (BE)
(74) Representative: Hatzmann, Martin

(57) **Abstract**

An apparatus is disclosed for treating a substance (2a, 2b, 2c) at a substrate (2), the substance having an electrical resistance. The apparatus comprises a first irradiation facility (4) that is arranged for heating the substance by irradiating the substance with infrared, visible and/or UV-radiation that is absorbed by the substance. Said heating by absorption causes a reduction of the electrical resistance of the substance with a first reduction factor greater than 1. The apparatus further comprises a second irradiation facility (8) that is arranged for subsequently resistively heating the irradiated substance by exposure to micro-wave radiation to further reduce the electrical resistance of the substance with a second reduction factor greater than 1.

## Description

### BACKGROUND OF THE INVENTION

### Field of the invention

The present invention relates to an apparatus for treating a substance at a substrate. The present invention further relates to a method for treating a substance at a substrate.

### Related Art

Printed, highly conductive inks, based on metal particles, metal-forming precursors or a combination thereof deposited on flexible substrates like PEN and PET, are often difficult to cure/sinter because of their relatively high curing temperature, which is often not compatible with polymeric substrates. As a result, it is difficult to find a method that effectively cures conductive ink lines into highly conductive (i.e., metal-like conductivities) tracks without deforming the polymeric substrate. One way to sinter conductive inks is to leave the printed ink lines in an oven at elevated temperatures (typically a few hundred degrees) for a certain period. Despite the high temperatures, the time it takes to cure/sinter the ink lines is relatively long (often 30 minutes and longer). More important is that the applied temperatures often are not compatible with the polymeric substrates, which typically have a transition (melting) temperature below 200 °C. The use of an oven for the sintering of nanoparticles inks or metal complex inks is quite old and has been extensively described in literature.

WO2006071419A2 discloses a method using pulsed photon radiation to sinter conductive inks on sensitive substrates (paper, foil, etc.). It is claimed therein that conductive tracks can be made by irradiation with a high power xenon lamp that generates a megaJoule per flash. The reported curing times are in the order of milliseconds, depending on the applied power.

It has been recognized by the inventors that when curing by pulsed photon radiation the cure level appears to be dependent on the size (width) of the features. Due to relatively high scattering effects thinner lines require more irradiation time to reach high conductivity levels than thick lines. This is disadvantageous if, as is often done in practice, a combination of thinner and thicker lines has to be cured.

### SUMMARY OF THE INVENTION

It is a purpose of the present invention to provide an apparatus that at least partly mitigates this disadvantage.

It is a further purpose of the present invention to provide a method that at least partly mitigates this disadvantage.

According to a first aspect of the present invention an apparatus is provided for treating a substance at a substrate, the substance having an electrical resistance, the apparatus comprising a first irradiation facility that is arranged for heating the substance by irradiating the substance with infrared, visible and/or UV-radiation that is absorbed by the substance, said heating by absorption causing a reduction of the electrical resistance of the substance with a first reduction factor greater than 1, and a second irradiation facility that is arranged for subsequently resistively heating the irradiated substance by exposure to micro-wave radiation to further reduce the electrical resistance of the substance with a second reduction factor greater than 1.

Irradiation of the substance at the substrate by the first irradiation facility causes the substance to dry and/or to cure partially, resulting in an improved electrical conductivity. Due to absorption of the radiation emitted by the first irradiation facility liquid evaporates from the substance and/or either particles in the substance will sinter and/or metal precursors in the substance decompose. Consequently, an electrically conductive pattern is formed that facilitates further curing by microwave treatment.

The microwave radiation couples predominantly with the substance that was rendered conductive by the irradiation with the first irradiation source, as it has a higher dielectric loss factor εᵣ. This results in selective heating of the deposited substance. Most of the heat generated by absorption of the microwave radiation develops in the electrical conductive pattern formed by the substance and causes this to anneal, thus to melt and/or to sinter, which in turn results in an improvement of desirable properties, such as conductivity or mechanical strength. It is believed that the conductive pattern interaction with microwave radiation, i.e. inductive coupling, is mainly based on Maxwell-Wagner polarization, which results from the accumulation of charge at the materials interfaces, electric conduction, and eddy currents. The substance subsequently has an induced internal electrical field and the electrical charge dissipates as heat into the material.

The microwave treatment results in homogeneous cure and conductivity levels, independent of the feature size. Furthermore, as a result of said improved conductivity achieved by radiation with the first irradiation source the subsequent exposure to microwave radiation is significantly more effective than would be the case of application of microwave radiation without the preceding irradiation by the first irradiation facility. If the substance were only treated by irradiation with the first irradiation facility substantially different results would be obtained dependent on the size of the features formed by the printed substance. Irradiation by the first irradiation facility followed by the second irradiation facility results in a relatively fast reduction of the resistivity of the substance independent of the size of the features formed therein.

Equipment to be used in the apparatus according to the first aspect of the invention can be chosen from known devices. Devices for depositing the substance, IR/UV-/VIS radiation generating devices, and microwave generators, are known in the art and commercially available.

It is noted that W02007039227 discloses a method for generating conductive surface patterns on a substrate by coating the substrate with metal particles and heating the coated substrate by means of microwave radiation. W02007039227 however does not suggest to irradiate the substance with photon radiation having a wavelength in the range of 400 to 900 nm prior to application of microwave radiation. According to the present invention the treatment by microwave radiation is preceded by irradiation of the substance with photon radiation having a wavelength in the range of 400 to 900. The synergy between these treatments allows for a significant reduction of process time as compared to a treatment by micro-wave radiation or a treatment by photon radiation in the specified wavelength range. No advantageous effect is obtained if the microwave treatment is applied prior to the photon radiation treatment.

The substance to be treated at the surface of the substrate may comprise metal particles, metal precursor particles, conductive polymer particles, molecular metal precursors, conductive organic compounds, suspended metal particles in a liquid, suspended metal precursor particles in a liquid, suspended conductive polymer particles, dissolved molecular metal precursors in a solution, dissolved conductive organic compounds or a combination thereof.

Suitable substrates can possess a large variety of properties. For example, they can be transparent or non-transparent, they can be crystalline or non-crystalline or they can contain adjuvants, such as pigments, antistatic agents, fillers, reinforcing materials, lubricants, processing aids and heat and/or light stabilizers. The nature of the substrates can also vary considerably. Non limiting examples are polymers (thermoplastic and duroplastic polymers including elastomers); inorganic materials, such as ceramic materials; or semi-conducting substrates. Preferred substrates are thermoplastic polymers, such as polyesters, for example polyethyleneterephthalate or polyethylenenaphtalate, polyamides, polyimides, polyether-imides, polycarbonates or polyolefins, such as polyethylene or polypropylene.

Preferably, sheet materials made from polymers are used. Examples thereof are thermoplastic materials in form of a sheet including composites containing said sheet materials. Very preferably polymer foils are used that are transparent in the range of 400 to 900 nm. Transparent means here that the foil absorbs less than 5 % of the radiation impinging on the surface of the foil.

Besides bulk materials, such as polymer moldings, e.g. foils, also fibrous substrates can be used. These can contain natural and/or man-made fibers. Examples of such substrates are paper or textile sheets including non-wovens.

The first reduction factor is typically in the range of 5 to 10000. In case the first reduction factor is substantially less than 5, e.g. less than 2 then the resistance of the substance is still so high that the treatment by the second irradiation facility is relatively inefficient. In case the first reduction factor is substantially larger than 10000, e.g. larger than 100000, then a relatively long irradiation time is required for irradiation by the first irradiation facility, while this does not result in an improvement of efficiency of the irradiation by the second irradiation facility.

The second reduction factor is typically in a range from 10 to 10000.

In an embodiment the first irradiation facility provides radiation having a wavelength of 400 to 900 nm.

Photon radiation having a wavelength in the range of 400 to 900 nm is in general substantially absorbed by the substance while being transmitted by the substrate. For particular combinations of substance and substrate the wavelength of the photon radiation may be restricted to a more narrow range of wavelengths. Most polymer substrates are partially transparent to both photons in the visible range and microwaves, allowing the selective heating of the ink on the substrate without any detrimental effect to the substrate.

The photon radiation may also comprise some radiation outside the specified wavelength range of 400 to 900 nm. However, to keep absorption of the photon radiation by the substrate at a modest level the photon radiation should be substantially comprised in said wavelength range. I.e. at least 50%, but more preferably at least 75% of the radiated power of the photon radiation should be in the specified wavelength range of 400 nm to 900 nm. Various substrates are at least partially transparent for the afore-mentioned wavelength range of 400-900 nm, while most substances to be deposited on the substrate generally have a good absorption for radiation in this wavelength range, or can be modified with radiation absorbing additives.

The power-density with which the substance at the surface of the substrate is radiated is typically in a range from 1 to 1000 W/cm2 , in particular in a range of 1 to 100 W/cm2, e.g. about 10 W/cm2.

In an embodiment the first irradiation facility provides the photon-radiation in a pulse-wise manner. By a pulse-wise application the substance that absorbs the radiation is allowed to cool down before a substantial amount of heat is transmitted by conduction to the substrate. This makes it possible to more selectively heat the substance to be treated. Therewith the substance can be heated to a higher temperature without increasing the heat load of the substrate. This is in particular favorable for substrates having a relatively low weakening temperature.

In an embodiment the photon radiation is provided with a pulse frequency in the range of 10 to 500 pulses per second. If the pulse frequency is substantially less than 10 pulses per second, e.g. less than 5 pulses per second, it becomes difficult to process the substrate at a sufficiently high linear speed in a roll to roll process at energy densities where the substrate is not affected. If the pulse frequency is substantially higher than 500 pulses per second, e.g. more than 1000 pulses per second the energy per pulse may become too low to result in a sufficient sintering of the metal seeds unless highly complicated high energy and high frequency power generators are used. In a practical embodiment the pulse frequency is for example in a range of 10 to 50 pulses per second, e.g. about 20 pulses per second.

The energy-density with which the substance at the surface of the substrate is radiated is typically in a range from 0.1 to 100 J/cm2 per flash, more typically in the range of 0.1 to J/cm2 e.g. about 1 J/cm2 per flash.

Microwave radiation is understood to be electro-magnetic radiation with wavelengths ranging from 1 mm to 1 m in free space corresponding to a frequency between approximately 300 GHz to 300 MHz, respectively.

An embodiment of the apparatus according to the first aspect of the invention further comprises a third irradiation facility for preparing the substance by exposure to UV-radiation before it is irradiated by the first irradiation facility. This embodiment is in particular suitable for treatment of substances comprising a metal complex precursor. It is believed that the radiation of the substance with a UV-radiation source results in a forming of metallic seeds in the metal complex precursor and that these metallic seeds provide for an increased absorbance during the subsequent radiation with the pulsed photon radiation source. A deposition facility for depositing the substance at a substrate may be integrated in the apparatus. A substrate handling facility may be present for automatically transporting the substrate from the substrate from the deposition facility, optionally via a third irradiation facility, to the first irradiation facility to the second irradiation facility.

According to a second aspect of the present invention a method is provided for treating a substance at a substrate, the method comprising the steps of
- heating the substance by irradiating the substance with infrared, visible and/or UV-radiation that is absorbed by the substance, said heating by absorption causing a reduction of the electrical resistance of the substance with a first reduction factor greater than 1,
- subsequently resistively heating the irradiated substance by exposure to micro-wave radiation to further reduce the electrical resistance of the substance with a second reduction factor greater than 1.

In an embodiment an antenna is provided in the form of an electrically conducting or a ferromagnetic sheet, wire or rod that is positioned in contact with or above the surface of the substrate carrying the substrate. Upon exposure of the microwave radiation the antenna will capture the micro-wave radiation more efficiently than the substance on the substrate. The energy of the micro-wave radiation will be transported from the antenna to the substance in a very efficient manner.

The apparatus and method according to the first and second aspect of the invention can be used to provide electrically conductive surface patterns on a substrate surface, for example, for the production of printed wiring boards, of integrated circuits, of decorative sheets, of data recording or of data storing media, print boards, of radio frequency identification tags (RFID tags), of organic light emitting devices (OLED), of thin-film transistors (TFT), of electrical devices, like heating elements, resistors, coils or antennae, of displays, of smart packages, of flexible circuits, of sensors or of photovoltaic devices.

### BRIEF DESCRIPTION OF THE DRAWINGS

These and other aspects are described in more detail with reference to the drawing. Therein:
FIG. 1 schematically shows an embodiment of an apparatus according to the first aspect of the invention,
FIG. 1A shows a detail according to view A in FIG. 1 of a substrate with a substance that is processed by the apparatus,
FIG. 1B shows a cross-section according to B-B in FIG. 1A,
FIG. 2A shows in more detail a part of the apparatus of FIG. 1,
FIG. 2B shows a cross-section of said part,
FIG. 2C shows a second cross-section according to C-C in FIG. 2B,
FIG. 3 shows an alternative embodiment of said part,
**FIG. 4A** shows a template used to test the apparatus and method according the first and second aspect of the invention,
**FIG. 4B** shows the template after a first processing step,
**FIG. 4C** shows an arrangement for measuring a resistance of a structure applied at the template,
**FIG. 5** shows results of the measurement.

### DETAILED DESCRIPTION OF EMBODIMENTS

In the following detailed description numerous specific details are set forth in order to provide a thorough understanding of the present invention. However, it will be understood by one skilled in the art that the present invention may be practiced without these specific details. In other instances, well known methods, procedures, and components have not been described in detail so as not to obscure aspects of the present invention.

In the drawings, the size and relative sizes of layers and regions may be exaggerated for clarity.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein. All publications, patent applications, patents, and other references mentioned herein are incorporated by reference in their entirety. In case of conflict, the present specification, including definitions, will control. In addition, the materials, methods, and examples are illustrative only and not intended to be limiting.

Like elements have like reference numerals.

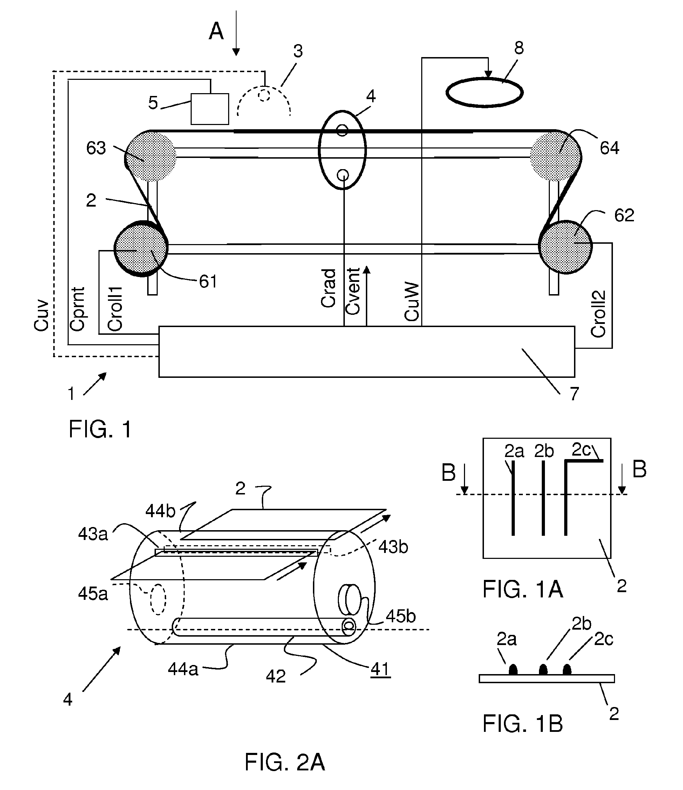

**FIG. 1** schematically shows an apparatus 1 for treating a substance 2a, 2b, 2c (See FIG 1A, 1B) at a substrate 2. The substance has an electrical resistance. The apparatus 1 comprises a first irradiation facility 4 that is arranged for heating the substance by irradiating the substance 2a, 2b, 2c with infrared, visible and/or UV-radiation that is absorbed by the substance 2a, 2b, 2c. The heating by absorption in the substance 2a, 2b, 2c causes a reduction of the electrical resistance of the substance 2 with a first reduction factor greater than 1. The apparatus comprises a second irradiation facility 8 that is arranged for subsequently resistively heating the irradiated substance 2a, 2b, 2c by exposure to micro-wave radiation. The resistive heating is caused by eddy-currents induced by the micro-wave radiation in the substance 2a, 2b, 2c and results in a further reduction of the electrical resistance of the substance with a second reduction factor greater than 1.

In the embodiment of FIG. 1 the apparatus 1 further comprises a substrate handling facility 61, 62, 63, 64 and a deposition facility 5. The substrate handling facility comprises a supply roll 61 for supplying the substrate 2, guidance rolls 63, 64 and a storage roll 62. The substrate 2 from the supply roll 61 is guided via guidance roll 63 towards the deposition facility 5. The deposition facility deposits the substance 2a, 2b, 2c to be treated in a desired pattern. The substrate is then subsequently guided along the first irradiation facility 4 and the second irradiation facility 8. The substrate 2 may be guided continuously or stepwise. In the embodiment shown the apparatus 1 further comprises a third irradiation facility 3 that is arranged between the deposition facility 5 and the first irradiation facility 5. The apparatus has a controller 7 for controlling the substrate handling facility 61-64 with control signals Croll1, Croll2, for controlling the deposition facility 5 with control signal Cprnt. The control facility 7 controls the first, the second and the third irradiation facility 4, 3 and 8 with control signals Crad, CuW and Cuv respectively. Additionally the control facility 7 controls a ventilation facility (not shown) with a control signal Cvent.

In the embodiment shown the deposition facility 5 is an inkjet printer. Another printing device may be used instead to deposit the substance, such as an offset printing, a gravure printing, a flexo printing, or (rotary) screen printing device. It is not necessary that the substance is deposited by a printing method. Instead other dispensing methods known in the art may be used, such as curtain coating, spin-coating, spray coating, dip coating, aerosol coating and coating by means of doctor blade.

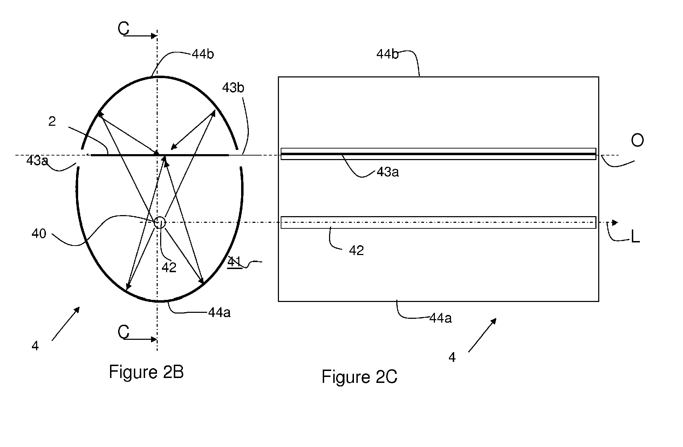

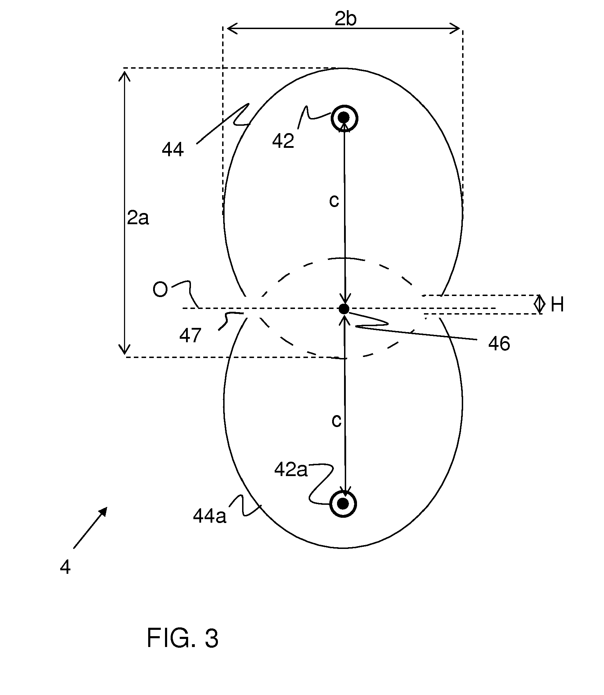

The first irradiation facility 4 comprises an XOP-15 strobe xenon lamp having an ATOMIC 3000 control unit of Martin Professionals A/S. The first irradiation facility 4 is described in more detail with reference to FIGs. 2A, 2B and 2C. An alternative first irradiation is described with reference to FIG. 3.

The second irradiation facility 8 is a microwave system. The microwave system may be a commercially available micro-wave system.

The third irradiation facility 3 optionally comprised in the apparatus is for example a radiation source of type UCL 300 of Electro-lite having a lamp ECL-400 with an output power of 100 mW/cm2 and a spectrum having a peak at 365 nm. FIG. 2A shows in a perspective view the first radiation facility 4 in more detail. The first irradiation facility 4 comprises a tube 41 in the form of an elliptic cylinder having a reflective inner surface. A tubular photon radiation source 42 is arranged concentric with a first focal line of the elliptic cylinder 41. The tube is provided with a first and a second slit-shaped 40 opening 43a, 43b that extend opposite to each other between a first and the second reflecting surface 44a, 44b in the direction of the length axis. The imaginary plane through the first and the second slit-shaped opening 43a, 43b is denoted herein as object-plane. During operation of the device the guiding rolls 63, 64 shown in FIG. 1 function as a guidance facility that guide the substrate 2 via the first slit-shaped opening 43a through a second focal line of the elliptical cylinder to the second slit-shaped opening 43b.

The tube 41 is provided with a ventilation system 45a, 45b controlled by signal Cvent.

**FIG. 2B** and **FIG. 2C** respectively show a cross-section transverse through a length axis L and a cross-section along the length axis L of the second radiation facility 4. The second cross-section is indicated as C-C in **FIG. 2B**.

In the embodiment shown the tubular photon radiation source 42 is the Xe-lamp of type Philips **XOP**-15 (length 39.5 cm, diameter about 1 cm). In a typical operational mode the photon radiation source 42 is driven at 75% of its maximum power of 1000 W and at a frequency of 10 flashes per second with a duration of 10 ms. Taking into account an efficiency of 65% of the lamp the power per pulse was estimated at 49 J. In the embodiment shown the radiation of lamp is concentrated in a region having a length of 39,5 cm and a width of 1 cm. The energy losses by imperfect reflection are estimated at 2%. As the lamp radiates most of its power, in this case more than 2/3, in the wavelength range of 400 to 700 nm the absorption in the substrate is negligible. Therewith the energy-density at the surface of the substrate is approximately 1.2 J/cm2 per flash. The power density is approximately 12 W/cm2.

**FIG. 3** shows in a cross-section an alternative arrangement of the first irradiation facility 4. Parts therein corresponding to those in FIGs. 2A, 2B and 2C have the same reference number.

In FIG. 3 the first irradiation facility 4 has a pair of concave reflective surfaces 44, 44a that are both formed by a section of a respective ellipsoidal cylinder that is coated at its inner side with aluminum foil having a reflectivity of 98%. The section is formed by truncation along the length axis of the cylinder. The truncated portion of the cylinder is indicated by the dotted lines. The concave reflective surfaces 44, 44a each have an own focal line in which a respective tubular photon radiator 42, 42a is arranged. The concave reflective surfaces 44, 44a additionally have a shared focal line 46. A gap 47, in this specific set-up having a height H of 10 mm, is present between the truncated elliptical cylinders 44, 44a. The gap 47 allows the substrate 2 to pass through the object-plane O through the shared focal line 46. In this specific set-up the ellipses in untruncated form would have a large axis 2a of 140 mm and a short axis 2b of 114.8 mm. Accordingly the distance c between their first and second focal lines is 80 mm. The second focal lines substantially coincide, in that their distance is less than one fifth (32 mm) the distance between the first focal lines. In particular the distance is less than one tenth (16 mm) the distance between the focal lines. In this case the second focal lines coincide with a tolerance of 1 mm.

The substance 2a, 2b, 2c deposited at the surface of the foil is for example an ink containing metal nano particles. An example thereof is a silver nanoparticle dispersion in an ethylene glycol/ethanol mixture as provided by Cabot (Cabot Printing Electronics and Displays, USA). This silver ink contains 20 wt% of silver nanoparticles, with the particle diameter ranging from 30 to 50 nm. The viscosity and surface tension of this ink is 14.4 mPa.s and 31 mN m-1, respectively.

Alternatively metal complexes in organic or water based solvents may be used as the substance, for example silver complex inks comprising a mixture of solvents and silver amides, for example inks produced by InkTec. The silver amides decompose at a certain temperature between 130-150°C into silver atoms, volatile amines and carbon dioxide. Once the solvents and the amines are evaporated, the silver atoms remain on the substrate. Other metal complexes based for example on copper, nickel, zinc, cobalt, palladium, gold, vanadium, and bismuth instead of silver may be used alternatively or in combination.

Other metal complexes based for example on copper, nickel, zinc, aluminum, cobalt, palladium, gold, vanadium, and bismuth instead of silver may be used alternatively or in combination. However, particularly suitable are a silver complex, a copper complex, a nickel-complex, an aluminum-complex or any mixture thereof. Silver, copper, aluminum and nickel are excellent conductors.

Some examples of copper complex based substances are shown in the following table.

**Table 1: Examples of substances comprising a Cu-complex component**

| |
|---|
| Cu(neodecanoate)2 (6-12% Cu; from Strem Chemicals) |
| Cu(acetate)2.H2O (from Sigma Aldrich) complex with ethanolamine is soluble in water (concentration N/A) |
| Cu(formate) 2.4 H2O (from Gelest) |

The electrically conductive structure to be formed from the substance may alternatively be conductive polymer structure. Such a structure can be formed from a substance that comprises conductive polymer particles, for example suspended in a liquid. Examples of electrically conductive polymers are poly-(3,4-ethylenedioxythiophene) (PEDOT) or polyaniline (PANI). Instead a substance comprising a suspension of particles of a precursor for a conductive polymer may be used.

In still other embodiments a solution with molecular metal precursors, and/or with conductive organic compounds, and/or with a precursor for a conductive organic compound may be used.

Furthermore the substance to be applied may be a paste instead of a liquid, e.g. a paste comprising metal nano particles or metal complex particles. Whether the substance is deposited in a paste or a liquid form may depend on the deposition method.

Typical mean particle diameters are in a range between 1 nm and 100µm, preferably 1 nm - 1 µm, very preferred 1 nm - 100 nm and especially preferred 1 nm — 50 nm. The mean particle diameter can be determined by transmission electron microscope (TEM). Very suitable are metal nanoparticles as they allow the formation of conducting surface patterns with a minimum amount of electromagnetic energy.

The apparatus according to the first aspect of the invention and the method according to the second aspect of the invention were experimentally verified as follows.

A silver nanoparticle dispersion in an ethylene glycol/ethanol mixture was purchased from Cabot (Cabot Printing Electronics and Displays, USA). The silver ink contains 20 wt% of silver nanoparticles, with the particle diameter ranging from 30 to 50 nm. The viscosity and surface tension of the ink were 14.4 mPa.s and 31 mN m-1, respectively.

As a substrate 2 was used a transparent, colourless polyethylene naphthalate (PEN, DuPont Teijin, The Netherlands, 125 µm thickness) film with a glass transition temperature of 120 °C. The foils were cleaned with ethanol. The silver nanoparticle dispersion was applied at the cleaned substrate 2 by inkjet printing using a piezoelectric inkjet printer of type Dimatix DMP 2800 (Dimatix-Fujifilm Inc., USA), equipped with a 10 pL cartridge (DMC-11610). The print head thereof contains 16 parallel squared nozzles with a diameter of 30 µm. The dispersion was printed using a customized wave form (average nozzle voltage 28 V, frequency of 20 kHz, meniscus set point 4 inches H2O, thickness of 700 µm, printing height 0.5 mm, drop spacing of 20 µm). The line width was set to a value of 100 µm.

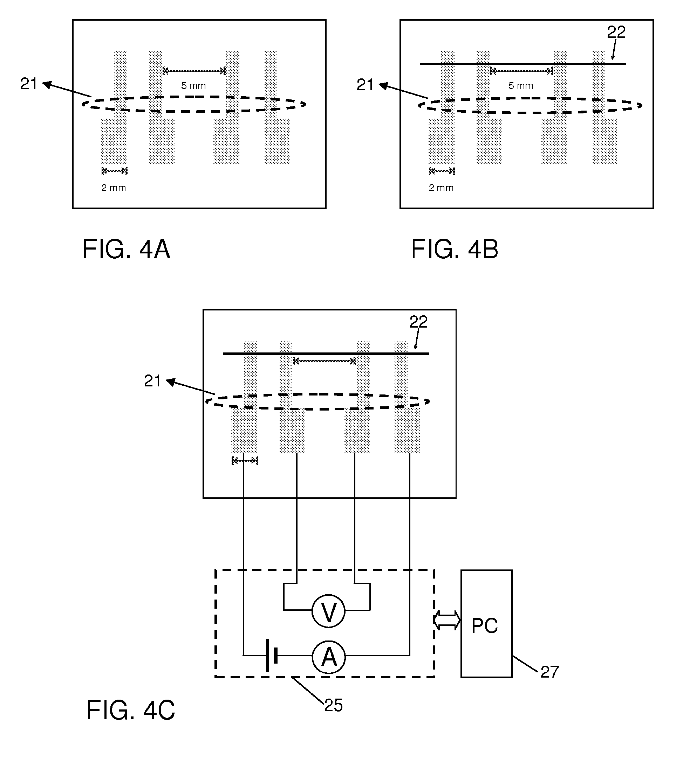

FIG. 4A shows a template that was used to conduct the experiments. A probe 21 was printed at the grey areas and sintered for 30 minutes in a Memmert Model 400 oven at a temperature of 135°C to achieve maximum conductivity prior to printing the pertinent ink line 22 (black line) as shown in FIG. 4B. The design of the probe 21 allows measuring the ink line 22 with a four-point resistance measurement. The total length of the line 22 is 1.6 cm. The portion of the line 22 extending between the middle pair of probes is 5 mm. The probe additionally functions as an antenna.

11 samples according to the pattern of FIG. 4B were prepared by irradiation by first irradiation facility 4 as described above directly controlled by controller 7 which allowed changing the settings of the irradiation facility 4. The specific settings used for photonic procuring were 50 % of the maximal intensity, an interval time (time between two pulses) of 1 s and 10 flashes per pulse. The 11 samples were irradiated at mutually different radiation times to obtain different resistivities. In this case the 11 samples so obtained had a resistivity in the range between about 465Ω and 57 MΩ. A 12th sample was not prepared by irradiation. This sample had an initial resistivity of 410 MΩ. All 12 samples were subjected to a micro-wave treatment during 1 s in capped reaction vials using a Biotage Initiator monomodal microwave system 8. For that purpose the microwave system 8 was operated at a frequency of 2.45 GHz, which corresponds to a wavelength of 12.2 cm. The power was set to its minimum of 1 W.

Surface topography, thickness and cross-sectional areas of printed silver tracks were measured with an optical profilometer (Fogale Zoomsurf, France). Scanning electron microscopy (SEM) images were taken using a FEG E-SEM XL30 (Philips, The Netherlands), after the samples had been coated with a thin layer of carbon.

To measure the profile of the photonically sintered ink line either a micro processor-based Dektak Surface Profiler was used and/or a Wyko Optical Profiler. Keithley 2400 source meters 25, were used to measure the four-point resistance prior to and after microwave sintering in the arrangement of FIG. 4C. A 1.0 mm FFC Connector from Tyco Electronics was used to connect probes on the template with the Keithley source meters 25. The source meters 25 are coupled to a general purpose computer 27 for processing of the measured data.

Table 2 shows for each of the 12 samples the relation between the initial resistance R4 after treatment by the first irradiation facility 4 and the resistance R8 obtained after the micro-wave treatment by the second irradiation facility 8 (vertical axis). Furthermore the table shows the value of the first reduction factor RED1 and the second reduction factor RED2.

**Table 2**

| Nr. | R4 (Ω) | R8(Ω) | RED1 | RED2 |
|---|---|---|---|---|
| 1 | 4.65E+02 | 8.05E+01 | 8.78E+05 | 5.78E+00 |
| 2 | 4.75E+02 | 3.00E+01 | 8.60E+05 | 1.58E+01 |
| 3 | 1.30E+03 | 4.80E+01 | 3.14E+05 | 2.71E+01 |
| 4 | 5.20E+03 | 3.40E+01 | 7.86E+04 | 1.53E+02 |
| 5 | 6.00E+03 | 3.50E+01 | 6.81E+04 | 1.71E+02 |
| 6 | 6.30E+03 | 3.20E+02 | 6.48E+04 | 1.97E+01 |
| 7 | 1.15E+04 | 4.90E+01 | 3.55E+04 | 2.35E+02 |
| 8 | 1.25E+04 | 2.88E+02 | 3.27E+04 | 4.34E+01 |
| 9 | 1.87E+04 | 1.25E+02 | 2.18E+04 | 1.50E+02 |
| 10 | 3.10E+05 | 1.40E+02 | 1.32E+03 | 2.21E+03 |
| 11 | 5.72E+07 | 2.10E+03 | 7.14E+00 | 2.72E+04 |
| 12 | 4.09E+08 | 4.00E+08 | 1.00E+00 | 1.02E+00 |

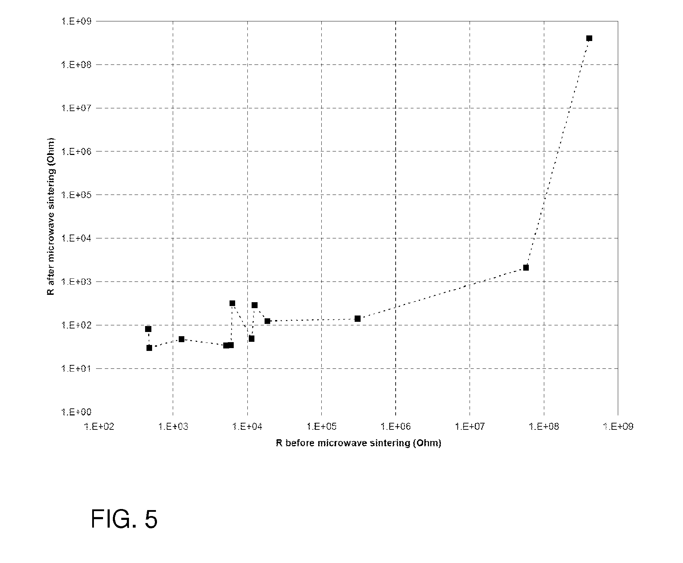

The relation between the initial resistance R4 and the final resistance R8 is also shown graphically in FIG. 5. Therein the horizontal axis represents the initial resistance R4 and the vertical axis represents the final resistance R8. The graph indicates that all samples that were pre-treated by the first irradiation facility 4 and post-treated by the second irradiation facility 8 have a relatively low final resistance of about 100 to 1000 Ω. The sample that was not pre-treated by irradiation with the first irradiation facility 8 approximately has maintained its high resistance of about 410 MΩ.

Samples 4 to 11 have a resistance R4 that is reduced with a factor RED1 in the range 7,14 to 78.600 as compared to the reference sample 12. This range is within the range of 2 to 100.000. For samples 10 and 11 the reduction factor RED1 is 7,14 and 1320 respectively, which is within the range of 5 to 10.000. It can be seen that a relatively modest first reduction RED1 as obtained with samples 10 and 11 already is sufficient to achieve a relatively low final resistance in the order of a few hundred or thousand kΩ, with a microwave treatment during only 1 second and at a relatively low power of 1W. Thereof, sample 11 gives the highest relative improvement by the post-treatment with microwave radiation. A very low final resistance final resistance is achieved with modest radiation doses in the first and the second radiation treatment when the first reduction factor has a value in the range of 1000 to 10.000, as is the case for sample 10.

For treatment of substances comprising metal complex components a further improvement of efficiency is obtained by irradiation with an UV-source 3.

By way of example the UV-source may be a Philips UV-C source having the following specification for the radiation intensity at the surface of the substrate.

**Table 3: Specification of a typical UV-source**

| Wave length (nm) | Intensity |
|---|---|
| | (µW/cm2) |
| 250 - 260 | 5306 |
| 360 - 370 | 129 |
| 310 - 390 (UVA) | 281 |
| 250 - 585 | 6239 |

In another embodiment an UV-source of type UCL 300 of Electro-lite having a lamp ECL-400 with an output power of 100 mW/cm2 and a spectrum having a peak at 365 nm may be used for this purpose.

While the invention has been illustrated and described in detail in the drawings and foregoing description, such illustration and description are to be considered illustrative and exemplary and not restrictive; the invention is not limited to the disclosed embodiments.

Other variations to the disclosed embodiments can be understood and effected by those skilled in the art in practicing the claimed invention, from a study of the drawings, the disclosure and the appended claims. In the claims the word "comprising" does not exclude other elements or steps, and the indefinite article "a" or "an" does not exclude a plurality. A single processor or other unit may fulfill the functions of several items recited in the claims. The mere fact that certain measures are recited in mutually different claims does not indicate that a combination of these measures cannot be used to advantage. Any reference signs in the claims should not be construed as limiting the scope.

## Claims

1. Apparatus (1) for treating a substance (2a, 2b, 2c) at a substrate (2), the substance having an electrical resistance, the apparatus comprising a first irradiation facility (4) that is arranged for heating the substance by irradiating the substance with infrared, visible and/or UV-radiation that is absorbed by the substance, said heating by absorption causing a reduction of the electrical resistance of the substance with a first reduction factor greater than 1, and a second irradiation facility (8) that is arranged for subsequently resistively heating the irradiated substance by exposure to micro-wave radiation to further reduce the electrical resistance of the substance with a second reduction factor greater than 1.

2. Apparatus according to claim 1, further comprising a deposition facility (5) for depositing the substance (2a, 2b, 2c) at a substrate (2).

3. Apparatus according to claim 1 or 2, wherein the radiation of the first irradiation facility is substantially comprised in the wavelength range of 400 to 900 nm.

4. Apparatus according to claim 1, wherein the first reduction factor has a value in a range of 2 to 100.000.

5. Apparatus according to claim 4, wherein the first reduction factor has a value in a range of 1000 to 10.000.

6. Apparatus according to claim 2 or 3, further comprising a third irradiation facility (3) for preparing the substance by exposure to UV-radiation before it is irradiated by the first irradiation facility (4).

7. Apparatus according to claim 1, comprising an antenna in the form of an electrically conducting or a ferromagnetic sheet, wire or rod that is positioned in contact with or above the surface of the substrate carrying the substrate.

8. Method for treating a substance at a substrate, the method comprising the steps of
- heating the substance by irradiating the substance with infrared, visible and/or UV-radiation that is absorbed by the substance, until a resistance of the substance is reduced with a first reduction factor having a value greater than 1,
- subsequently exposing the irradiated substance to micro-wave radiation until the resistance of the substance is further reduced with a second reduction factor having a value greater than 1.

9. Method according to claim 8, wherein the substance comprises a precursor for an electrically conductive substance.

10. Method according to claim 9, wherein the precursor is a metal-complex.

11. Method according to claim 8, wherein the substance comprises a composition with metal particles.

12. Method according to claim 8, wherein the substance comprises conductive polymer particles.

13. Method according to claim 8, wherein the substance comprises particles of a precursor for a conductive polymer.

14. Method according to claim 8, comprising the step of providing an antenna in the form of an electrically conducting or a ferromagnetic sheet, wire or rod that is positioned in contact with or above the surface of the substrate carrying the substrate.
